# EUROPEAN PATENT APPLICATION

(11) **EP 4 383 485 A1**
(43) Date of publication of application: **12.06.2024**
(21) Application number: 22852881.6
(22) Date of filing: 25.07.2022
(51) Int. Cl.: H01S 5/183, H01S 5/343

(54) **VERTICAL-RESONATOR-TYPE LIGHT-EMITTING ELEMENT**

(30) Priority: 03.08.2021 JP 2021127606
(71) Applicant: Stanley Electric Co., Ltd., Meguro-ku Tokyo 153-8636 (JP)
(72) Inventor: KURAMOTO, Masaru, Tokyo 153-8636 (JP)
(74) Representative: Wimmer, Hubert
(86) International application number: PCT/JP2022/028640
(87) International publication number: WO 2023/013457

(57) **Abstract**

To provide a vertical cavity light-emitting element capable of stably emitting a light having a specific polarization direction. A vertical cavity light-emitting element of the present invention includes a gallium-nitride-based semiconductor substrate, a first multilayer reflector, a semiconductor structure layer, a second multilayer reflector, and a current confinement structure. The first multilayer reflector is formed on the substrate. The semiconductor structure layer includes a first semiconductor layer, an active layer, and a second semiconductor layer. The first semiconductor layer having a first conductivity type is formed on the first multilayer reflector. The active layer is formed on the first semiconductor layer. The second semiconductor layer is formed on the active layer and has a second conductivity type opposite to the first conductivity type. The second multilayer reflector is formed on the semiconductor structure layer and constitutes a resonator with the first multilayer reflector. The current confinement structure is formed between the first multilayer reflector and the second multilayer reflector to concentrate a current in one region of the active layer. A diffraction grating is formed in a region overlapping with the one region when viewed from a normal direction of an upper surface of the substrate. The diffraction grating is made of a plurality of slit structures parallel to each other.

## Description

### TECHNICAL FIELD

The present invention relates to a vertical cavity light-emitting element, such as a vertical cavity surface emitting laser (VCSEL).

### BACKGROUND ART

Conventionally, as one of semiconductor lasers, there has been known a vertical cavity-type semiconductor surface emitting laser (hereinafter also simply referred to as a surface emitting laser) including a semiconductor layer that emits a light by application of voltage and multilayer reflectors opposed to one another with the semiconductor layer interposed therebetween. For example, Patent Document 1 discloses a vertical cavity-type semiconductor laser having an n-electrode and a p-electrode respectively connected to an n-type semiconductor layer and a p-type semiconductor layer.

Patent Document 1: Japanese Unexamined Patent Application Publication No. 2017-98328

### DISCLOSURE OF THE INVENTION

### PROBLEMS TO BE SOLVED BY THE INVENTION

For example, an optical resonator is formed with opposed reflectors in a vertical cavity light-emitting element such as a surface emitting laser. For example, in the surface emitting laser, by application of voltage to a semiconductor layer via electrodes, a light emitted from the semiconductor layer resonates in the optical resonator to generate a laser light.

However, as an example of a problem, for example, a vertical cavity-type semiconductor laser element has luminous efficiency lower than that of a horizontal cavity-type semiconductor laser having a resonator in an in-plane direction of a semiconductor layer including an active layer.

Lights emitted from the vertical cavity-type semiconductor laser element using a GaN-based substrate have often been elliptically polarized, or linearly polarized with different polarization directions. It has been difficult to stabilize the polarization direction during operation, for example, the polarization direction changes depending on changes in a driving current and an operating temperature.

The present invention has been made in consideration of the above-described points and an object of which is to provide a vertical cavity light-emitting element having high luminous efficiency and capable of stably emitting a light having a specific polarization direction.

### SOLUTIONS TO THE PROBLEMS

The vertical cavity light-emitting element according to the present invention comprises: a gallium-nitride-based semiconductor substrate; a first multilayer reflector made of a nitride semiconductor formed on the substrate; a semiconductor structure layer including a first semiconductor layer, an active layer, and a second semiconductor layer, the first semiconductor layer being made of a nitride semiconductor having a first conductivity type formed on the first multilayer reflector, the active layer being made of a nitride semiconductor formed on the first semiconductor layer, the second semiconductor layer being formed on the active layer and made of a nitride semiconductor having a second conductivity type opposite to the first conductivity type; a second multilayer reflector formed on the semiconductor structure layer, the second multilayer reflector constituting a resonator with the first multilayer reflector; and a current confinement structure formed between the first multilayer reflector and the second multilayer reflector to concentrate a current in one region of the active layer, wherein a diffraction grating is formed in a region overlapping with the one region when viewed from a normal direction of an upper surface of the gallium-nitride-based semiconductor substrate, the diffraction grating being made of a plurality of slit structures parallel to each other.

### BRIEF DESCRIPTION OF DRAWINGS

Fig. 1 is a perspective view of a surface emitting laser according to a first embodiment.
Fig. 2 is a top plan view of a surface emitting laser according to the first embodiment.
Fig. 3 is a cross-sectional view of a surface emitting laser according to the first embodiment.
Fig. 4 is a cross-sectional view of a surface emitting laser according to a second embodiment.
Fig. 5 is a cross-sectional view of a surface emitting laser according to a third embodiment.
Fig. 6 is a cross-sectional view of a surface emitting laser according to a fourth embodiment.
Fig. 7 is a cross-sectional view of a surface emitting laser according to a fifth embodiment.
Fig. 8 is a cross-sectional view of a surface emitting laser according to a modification example.

### DESCRIPTION OF PREFERRED EMBODIMENTS

The following describes embodiments of the present invention in detail. While, in the following description, a description will be made using a semiconductor surface emitting laser element as an example, the present invention is applicable not only to a surface emitting laser but also to various kinds of vertical cavity light-emitting elements, such as a vertical cavity-type light-emitting diode.

### Embodiment 1

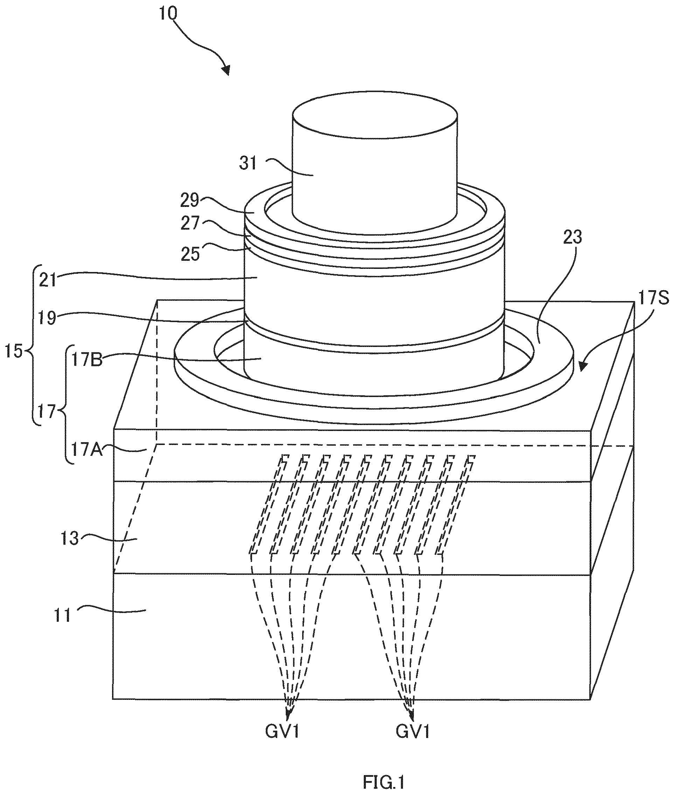

FIG. 1 is a perspective view of a vertical cavity surface emitting laser (VCSEL, hereinafter also simply referred to as a surface emitting laser) 10 according to Embodiment 1.

A substrate 11 is a gallium-nitride-based semiconductor substrate, for example, a GaN substrate. The substrate 11 is, for example, a substrate having a rectangular upper surface shape. The substrate 11 is a coreless substrate manufactured such that dislocations are uniformly distributed thereover, and cores, which are aggregates of dislocation defects, are not formed.

An upper surface of the substrate 11 is a surface that is offset from a C-plane by 0.5° in an M-plane direction. The upper surface of the substrate 11 is hardly offset from the C-plane in an A-plane direction, and an off angle from the C-plane in the A-plane direction is 0 ± 0.01°.

In a region including a center portion of the upper surface of the substrate 11, slit grooves GV1 are formed. The slit grooves GV1 are a plurality of slit structures each of which extends in a direction along an m-axis and is arranged in a lattice shape.

The first multilayer reflector 13 is a semiconductor multilayer reflector made of a semiconductor layer that has been grown on the substrate 11. The first multilayer reflector 13 is formed by alternately stacking a low refractive-index semiconductor film having a composition of AlInN and a high refractive-index semiconductor film having a GaN composition and having a refractive index higher than that of the low refractive-index semiconductor film. In other words, the first multilayer reflector 13 is a distributed Bragg reflector (DBR) made of a semiconductor material.

The first multilayer reflector 13 is formed by, for example, providing a buffer layer having the GaN composition on the upper surface of the substrate 11, and alternately forming films of the high refractive-index semiconductor film and the low refractive-index semiconductor film described above on the buffer layer.

A semiconductor structure layer 15 is a stacked structure made of a plurality of semiconductor layers formed on the first multilayer reflector 13. The semiconductor structure layer 15 has an n-type semiconductor layer (a first semiconductor layer) 17 formed on the first multilayer reflector 13, a light-emitting layer (or an active layer) 19 formed on the n-type semiconductor layer 17, and a p-type semiconductor layer (a second semiconductor layer) 21 formed on the active layer 19.

The n-type semiconductor layer 17 as a first conductivity type semiconductor layer is a semiconductor layer formed on the first multilayer reflector 13. The n-type semiconductor layer 17 is a semiconductor layer that has the GaN composition and is doped with Si as n-type impurities. The n-type semiconductor layer 17 has a prismatic-shaped lower portion 17A and a column-shaped upper portion 17B disposed on the lower portion 17A. Specifically, for example, the n-type semiconductor layer 17 has the column-shaped upper portion 17B projecting from an upper surface 17S of the prismatic-shaped lower portion 17A. In other words, the n-type semiconductor layer 17 has a mesa-shaped structure including the upper portion 17B.

The active layer 19 is a layer that is formed on the upper portion 17B of the n-type semiconductor layer 17 and has a quantum well structure including a well layer having an InGaN composition and a barrier layer having the GaN composition. In a surface emitting laser 10, a light is generated in the active layer 19.

The p-type semiconductor layer 21 as a second conductivity type semiconductor layer is a semiconductor layer having the GaN composition formed on the active layer 19. The p-type semiconductor layer 21 is doped with Mg as p-type impurities.

An n-electrode 23 is a metal electrode that is disposed on the upper surface 17S of the lower portion 17A of the n-type semiconductor layer 17 and is electrically connected to the n-type semiconductor layer 17. The n-electrode 23 is formed into a ring shape so as to surround the upper portion 17B of the n-type semiconductor layer 17. The n-electrode 23 forms a first electrode layer that is electrically in contact with the n-type semiconductor layer 17 and supplies an external current to the semiconductor structure layer 15.

An insulating layer 25 is a layer made of an insulator formed on the p-type semiconductor layer 21. The insulating layer 25 is formed of, for example, a substance having a refractive index lower than that of a material forming the p-type semiconductor layer 21, such as SiO₂. The insulating layer 25 is formed into a ring shape on the p-type semiconductor layer 21 and has an opening (not illustrated) in a central portion that exposes the p-type semiconductor layer 21.

A transparent electrode 27 is a metal oxide film having translucency formed on an upper surface of the insulating layer 25. The transparent electrode 27 covers the entire upper surface of the insulating layer 25 and an entire upper surface of the p-type semiconductor layer 21 exposed through the opening formed in the central portion of the insulating layer 25. As the metal oxide film forming the transparent electrode 27, for example, ITO or IZO having translucency to an emitted light from the active layer 19 can be used.

A p-electrode 29 is a metal electrode formed on the transparent electrode 27. The p-electrode 29 is electrically connected to the upper surface of the p-type semiconductor layer 21 exposed through the opening of the insulating layer 25 via the transparent electrode 27. The transparent electrode 27 and the p-electrode 29 form a second electrode-layer that is electrically in contact with the p-type semiconductor layer 21 and supplies the external current to the semiconductor structure layer 15. In the embodiment, the p-electrode 29 is formed into a ring shape on an upper surface of the transparent electrode 27 along an outer edge of the upper surface.

A second multilayer reflector 31 is a column-shaped multilayer reflector formed in a region surrounded by the p-electrode 29 on the upper surface of the transparent electrode 27. The second multilayer reflector 31 is a dielectric multilayer reflector in which a low refractive index dielectric film made of Al₂O₃ and a high refractive index dielectric film made of Ta₂O₅ and having a refractive index higher than that of the low refractive index dielectric film are alternately stacked. In other words, the second multilayer reflector 31 is the distributed Bragg reflector (DBR) made of a dielectric material.

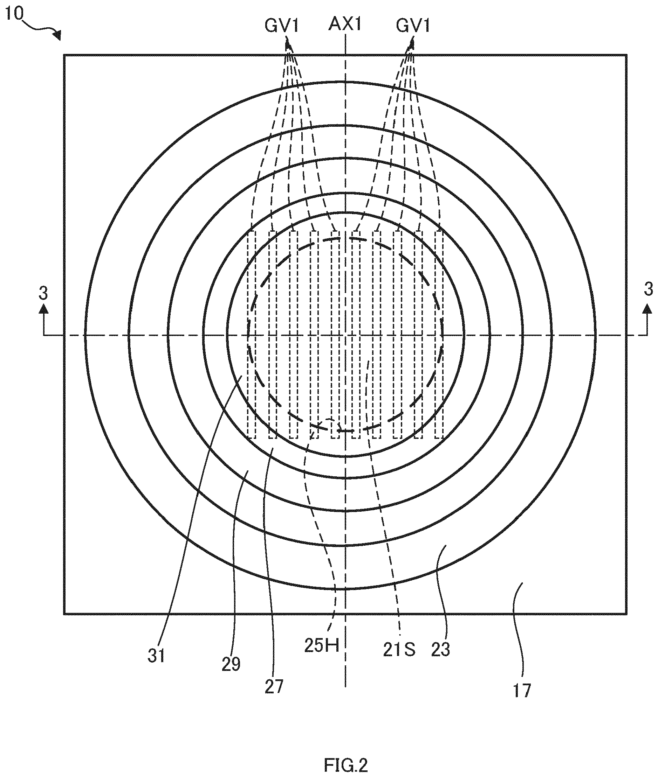

FIG. 2 is a top view of the surface emitting laser 10. As described above, the surface emitting laser 10 has the semiconductor structure layer 15 including the n-type semiconductor layer 17 formed on the substrate 11 having the rectangular upper surface shape, the active layer 19 having the circular-shaped upper surface, and the p-type semiconductor layer 21 (see FIG. 1). The insulating layer 25 and the transparent electrode 27 are formed on the p-type semiconductor layer 21. The p-electrode 29 and the second multilayer reflector 31 are formed on the transparent electrode 27.

In FIG. 2, an axis that passes through the center of the surface emitting laser 10 and is along an m-axis direction of the substrate 11, that is, a direction in which the slit grooves GV1 formed on the upper surface of the substrate 11 extend is an axis AX1.

The insulating layer 25 has an opening 25H as a circular-shaped opening that exposes the p-type semiconductor layer 21 of the above-described insulating layer 25. As illustrated in FIG. 2, the opening 25H is formed at a center portion of the insulating layer 25 when viewed from an upper side of the surface emitting laser 10 and is covered with the second multilayer reflector 31 when viewed from the upper side of the surface emitting laser 10. In other words, the opening 25H is formed in a region opposed to a lower surface of the second multilayer reflector 31 of the insulating layer 25.

The opening 25H has a circular shape having a center on the axis AX1. Accordingly, the p-type semiconductor layer 21 is electrically connected to the transparent electrode 27 via an electrical contact surface 21S in a circular region exposed through the opening 25H on the upper surface of the p-type semiconductor layer 21.

As shown in FIG. 2, the slit grooves GV1 extend parallel to each other and are formed over a region opposed to the electrical contact surface 21S with the semiconductor structure layer 15 and the first multilayer reflector 13 interposed therebetween. In other words, the slit grooves GV1 are formed so as to overlap with the electrical contact surface 21S in a top view, that is, in a normal direction of the upper surface of the substrate 11.

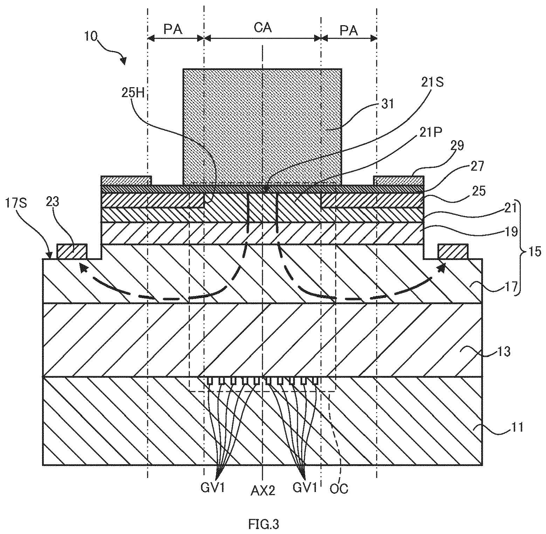

FIG. 3 is a cross-sectional view of the surface emitting laser 10 taken along the line 3-3 in FIG. 2. As described above, the surface emitting laser 10 has the substrate 11 as the GaN substrate, and the first multilayer reflector 13 is formed on the substrate 11. Note that a lower surface of the substrate 11 may be applied with an AR coating.

Each of the slit grooves GV1 formed on the upper surface of the substrate 11 forms a void together with a lower surface of the first multilayer reflector 13. In other words, the first multilayer reflector 13 is formed so as to cover the slit grooves GV1, and the semiconductor material forming the first multilayer reflector 13 is not filled in the slit grooves GV1. That is, a diffraction grating structure made of a plurality of voids extending in the axis AX1 direction (direction perpendicular to the paper surface of FIG. 3) is formed between the first multilayer reflector 13 and the substrate 11.

The semiconductor structure layer 15 is formed on the first multilayer reflector 13. The semiconductor structure layer 15 is a stacked body made by forming the n-type semiconductor layer 17, the active layer 19, and the p-type semiconductor layer 21 in this order. A projecting portion 21P protruding upward is formed at a center portion of the upper surface of the p-type semiconductor layer 21.

The insulating layer 25 is formed so as to cover a region other than the projecting portion 21P of the upper surface of the p-type semiconductor layer 21. As described above, the insulating layer 25 is made of a material having a refractive index lower than that of the p-type semiconductor layer 21. The insulating layer 25 has the opening 25H that exposes the projecting portion 21P. For example, the opening 25H and the projecting portion 21P have similar shapes, and an inner surface of the opening 25H and an outer surface of the projecting portion 21P are in contact with one another.

The transparent electrode 27 is formed so as to cover the insulating layer 25 and an upper surface of the projecting portion 21P exposed through the opening 25H of the insulating layer 25. That is, the transparent electrode 27 is electrically in contact with the p-type semiconductor layer 21 in the region exposed through the opening 25H on the upper surface of the p-type semiconductor layer 21. In other words, the region exposed through the opening 25H on the upper surface of the p-type semiconductor layer 21 is the electrical contact surface 21S that provides electrical contact between the p-type semiconductor layer 21 and the transparent electrode 27.

As described above, the p-electrode 29 is the metal electrode and is formed along the outer edge of the upper surface of the transparent electrode 27. That is, the p-electrode 29 is electrically in contact with the transparent electrode 27. Accordingly, the p-electrode 29 is electrically in contact with or electrically connected to the p-type semiconductor layer 21 via the transparent electrode 27 on the electrical contact surface 21S exposed through the opening 25H on the upper surface of the p-type semiconductor layer 21.

The second multilayer reflector 31 is formed in a region on the opening 25H of the insulating layer 25 on the upper surface of the transparent electrode 27, in other words, in a region on the electrical contact surface 21S, that is, a central portion of the upper surface of the transparent electrode 27. The lower surface of the second multilayer reflector 31 is opposed to an upper surface of the first multilayer reflector 13 with the transparent electrode 27 and the semiconductor structure layer 15 interposed therebetween. Due to the arrangement of the first multilayer reflector 13 and the second multilayer reflector 31, the first multilayer reflector 13 and the second multilayer reflector 31 form a resonator OC that resonates the light emitted from the active layer 19.

In the surface emitting laser 10, the first multilayer reflector 13 has a reflectivity slightly lower than that of the second multilayer reflector 31. Accordingly, a part of the light resonated between the first multilayer reflector 13 and the second multilayer reflector 31 transmits through the first multilayer reflector 13 and the substrate 11 to be taken out to the outside.

Here, an operation of the surface emitting laser 10 will be described. In the surface emitting laser 10, when a voltage is applied between the n-electrode 23 and the p-electrode 29, a current flows in the semiconductor structure layer 15 as indicated by the one-dot chain bold line in the drawing, and the light is emitted from the active layer 19. The light emitted from the active layer 19 is repeatedly reflected between the first multilayer reflector 13 with the slit grooves GV1 and the second multilayer reflector 31 to reach a resonant state (that is, to laser oscillate).

In the surface emitting laser 10, the current is injected only from a portion exposed through the opening 25H, that is, the electrical contact surface 21S to the p-type semiconductor layer 21. Since the p-type semiconductor layer 21 is considerably thin, the current does not diffuse in the in-plane direction in the p-type semiconductor layer 21, that is, the direction along the in-plane of the semiconductor structure layer 15.

Accordingly, in the surface emitting laser 10, the current is supplied only to a region in the active layer 19 immediately below the electrical contact surface 21S defined by the opening 25H, and the light is emitted only from this region. That is, in the surface emitting laser 10, the opening 25H has a current confinement structure that restricts a supply range of the current in the active layer 19.

In other words, in the surface emitting laser 10, the current confinement structure is formed between the first multilayer reflector 13 and the second multilayer reflector 31. The current confinement structure confines the current such that the current flows only in a central region CA, which is a column-shaped region with the electrical contact surface 21S as a bottom surface, of the active layer 19, that is, the current is concentrated by the current confinement structure in one region of the active layer. The central region CA including a region in which the current flows in the active layer19 is defined by the electrical contact surface 21S.

As described above, in the embodiment, the first multilayer reflector 13 has the reflectivity lower than that of the second multilayer reflector 31. Accordingly, a part of the light resonated between the first multilayer reflector 13 and the second multilayer reflector 31 is transmitted to the slit grooves GV1 and also resonates between the second multilayer reflector 31 and the slit grooves GV1. The part of the resonated light transmits through the first multilayer reflector 13, the slit grooves GV1, and the substrate 11 to be taken out to the outside. Thus, the surface emitting laser 10 emits the light from the lower surface of the substrate 11 in the direction perpendicular to the lower surface of the substrate 11 and the in-plane direction of the respective layers of the semiconductor structure layer 15. In other words, the lower surface of the substrate 11 is a light emitting surface of the surface emitting laser 10.

The electrical contact surface 21S of the p-type semiconductor layer 21 of the semiconductor structure layer 15 and the opening 25H of the insulating layer 25 define a luminescence center as a center of a light emission region in the active layer 19 to define a center axis (a luminescence center axis) AX2 of the resonator OC. The center axis AX2 of the resonator OC passes through a center of the electrical contact surface 21S of the p-type semiconductor layer 21 and extends along a direction perpendicular to the in-plane direction of the semiconductor structure layer 15.

The light emission region of the active layer 19 is, for example, a region having a predetermined width from which a light having a predetermined intensity or more is emitted in the active layer 19, and its center is the luminescence center. For example, the light emission region of the active layer 19 is a region to which a current having a predetermined density or more is injected in the active layer 19, and its center is the luminescence center. A straight line that passes through the luminescence center and is perpendicular to the upper surface of the substrate 11 or the in-plane direction of the respective layers of the semiconductor structure layer 15 is the center axis AX2.

The luminescence center axis AX2 is a straight line extending along a resonator length direction of the resonator OC constituted of the first multilayer reflector 13 and the second multilayer reflector 31. The center axis AX2 corresponds to an optical axis of the laser light emitted from the surface emitting laser 10.

Here, exemplary configurations of respective layers of the first multilayer reflector 13, the semiconductor structure layer 15, and the second multilayer reflector 31 in the surface emitting laser 10 will be described. In the embodiment, the first multilayer reflector 13 is made of a GaN base layer of 1 µm and 42 pairs of n-GaN layers and AlInN layers formed on the upper surface of the substrate 11.

The n-type semiconductor layer 17 is an n-GaN layer having a layer thickness of 1580 nm. The active layer 19 is made of an active layer having a multiple quantum well structure in which four pairs of GaInN layers of 4 nm and GaN layers of 5 nm are stacked. On the active layer 19, an AlGaN electronic barrier layer doped with Mg is formed, and the p-type semiconductor layer 21 made of a p-GaN layer of 50 nm is formed thereon. The second multilayer reflector 31 is made by stacking 10.5 pairs of Nb₂O₅ and SiO₂. The resonant wavelength in this case was 440 nm.

The insulating layer 25 is a layer made of SiO₂ of 20 nm. In other words, the projecting portion 21P on the upper surface of the p-type semiconductor layer 21 protrudes by 20 nm from the periphery. That is, the p-type semiconductor layer 21 has a layer thickness of 50 nm in the projecting portion 21P, and has a layer thickness of 30 nm in the other region. The upper surface of the insulating layer 25 is configured to be arranged at a height position identical to the upper surface of the projecting portion 21P of the p-type semiconductor layer 21. These configurations are merely examples.

The following describes optical features inside the surface emitting laser 10. As described above, in the surface emitting laser 10, the insulating layer 25 has a refractive index lower than that of the p-type semiconductor layer 21. Between the first multilayer reflector 13 and the second multilayer reflector 31, the layer thicknesses of the active layer 19 and the n-type semiconductor layer 17 are the same at any position in the plane in the same layer.

Accordingly, an equivalent refractive index (an optical distance between the first multilayer reflector 13 and the second multilayer reflector 31, and corresponds to a resonant wavelength) in the resonator OC formed between the first multilayer reflector 13 and the second multilayer reflector 31 of the surface emitting laser 10 differs in the column-shaped central region CA with the electrical contact surface 21S as a bottom surface and in a pipe-shaped peripheral region PA around the central region CA by a difference in refractive indexes between the p-type semiconductor layer 21 and the insulating layer 25.

Specifically, between the first multilayer reflector 13 and the second multilayer reflector 31, the equivalent refractive index in the peripheral region PA is lower than the equivalent refractive index in the central region CA, that is, an equivalent resonant wavelength in the central region CA is smaller than the equivalent resonant wavelength in the peripheral region PA. Note that where the light is emitted in the active layer 19 is the region immediately below the opening 25H and the electrical contact surface 21S. That is, the light emission region where the light is emitted in the active layer 19 is a portion overlapping with the central region CA in the active layer 19, in other words, a region overlapping with the electrical contact surface 21S in a top view.

Thus, in the surface emitting laser 10, the central region CA including the light emission region of the active layer 19 and the peripheral region PA that surrounds the central region CA and has the refractive index lower than that of the central region CA are formed. This reduces an optical loss by diffusion (radiation) of a standing wave within the central region CA into the peripheral region PA. That is, a large amount of light remains in the central region CA, and a laser light is taken out to the outside in this state. Accordingly, the large amount of light concentrates in the central region CA in the peripheral area of the luminescence center axis AX2 of the resonator OC to ensure generating and emitting a laser light with high output and high density.

As described above, in the surface emitting laser 10 of the embodiment, the upper surface of the substrate 11 is a surface that is offset from the C-plane by 0.5° in the M-plane direction. When the semiconductor layer is grown in a growth surface offset to the M-plane of the substrate 11 like the surface emitting laser 10 of this embodiment, an optical gain of a light having a polarization direction in the m-axis direction becomes larger than a light having a polarization direction in other directions, and thus, the laser light having the polarization direction in the m-axis direction easily oscillates. Thus, in the light emitted from the central region CA of the surface emitting laser 10, a large amount of light has the polarization direction in the m-axis direction.

In the surface emitting laser 10, a diffraction grating is formed in a region including the center portion of the upper surface of the substrate 11. The diffraction grating is made of a hollow space formed of a plurality of grooves GV1 each of which extends in the direction along the m-axis and is arranged in a lattice shape.

The diffraction grating formed of the slit grooves GV1 provides a high reflectivity for a light having a polarization direction in an extending direction of each of the slit grooves GV1 forming the diffraction grating, that is, in the m-axis direction, in the central region CA of a reflective structure formed of the first multilayer reflector 13.

That is, since the slit grooves GV1 are formed, the reflectivity of the light having the polarization direction in the m-axis direction is higher than that of the light having the other polarization directions, and the light having the polarization direction in the m-axis direction is likely to oscillate preferentially. That is, the slit grooves GV1 reduces loss of the light having the polarization direction along the m-axis direction of the surface emitting laser 10.

Accordingly, in the surface emitting laser 10, the semiconductor structure layer 15 is grown on the upper surface of the substrate 11 as a surface offset from the C-plane to the M-plane, and the diffraction grating structure made of the slit grooves GV1 extending along the m-axis is formed on the upper surface of the substrate 11. With such a configuration, the surface emitting laser 10 allows to stably obtain an emitted light in which a light having one polarization direction, specifically, the polarization direction along the m-axis direction, is dominant.

In view of the fact that the diffraction grating structure formed of the slit grooves GV1 described above has a high reflectivity for the light having the polarization direction in the m-axis direction, the slit grooves GV1 preferably have approximately the same width as a wavelength of the light emitted from the active layer 19. Preferably, the slit grooves GV1 are disposed at approximately the same intervals as the wavelength of the light emitted from the active layer 19.

The slit grooves GV1 may extend further outward from a region opposed to the opening 25H, that is, the central region CA. The slit grooves GV1 may be arranged even to an outside of the central region CA.

When the surface emitting laser 10 of Embodiment 1 was actually driven to confirm the polarization direction of the emitted light, it was confirmed that the emitted light in which the light having the polarization direction in the m-axis direction is dominant can be stably obtained under the condition that a device temperature is from 20°C to 80°C when driven by a drive current of 3 mA to 13 mA.

As described above, with the surface emitting laser of the present invention, it is possible to have high luminous efficiency and stably obtain the emitted light having a specific polarization direction. This is very effective when the emitted light of the surface emitting laser is used in a device having an optical system using a liquid crystal or a polarizer.

### (Manufacturing Method)

The following describes one example of a method for manufacturing the surface emitting laser 10. First, as the substrate 11, an n-GaN substrate having an upper surface that is a crystal face inclined from the C-plane to the M-plane as described above is prepared, and the slit grooves GV1 are formed on the upper surface by exposure patterning and dry etching. Subsequently, an n-GaN layer (layer thickness of 1 µm) is formed as a base layer on the upper surface of the substrate 11 by metal-organic vapor phase epitaxy (MOVPE). Subsequently, 42 pairs of n-GaN/AlInN layers are film-formed on the base layer to form the first multilayer reflector 13.

Next, the active layer 19 is formed by forming Si-doped n-GaN (layer thickness of 1580 nm) on the first multilayer reflector 13 to form the n-type semiconductor layer 17, and then, stacking four pairs of layers made of GaInN (layer thickness of 4 nm) and GaN (layer thickness of 5 nm) on the n-type semiconductor layer 17.

Next, the electronic barrier layer (not illustrated) made of Mg-doped AlGaN is formed on the active layer 19, and then, p-GaN layer (layer thickness of 50 nm) is film-formed on the electronic barrier layer to form the p-type semiconductor layer 21.

Next, a peripheral portion of the p-type semiconductor layer 21, the active layer 19, and the n-type semiconductor layer 17 is etched to form a mesa shape such that the upper surface 17S of the n-type semiconductor layer 17 is exposed in the peripheral portion. In other words, in this process, the semiconductor structure layer 15 including a column shaped portion made of the n-type semiconductor layer 17, the active layer 19, and the p-type semiconductor layer 21 in FIG. 1 is completed.

Next, the periphery of the center portion of the upper surface of the p-type semiconductor layer 21 is etched to form the projecting portion 21P. Subsequently, the insulating layer 25 is formed by forming a film of SiO₂ on the semiconductor structure layer 15 and removing a part of the film to form the opening 25H. In other words, SiO₂ is embedded in the etched and removed portion of the upper surface of the p-type semiconductor layer 21.

Next, the transparent electrode 27 is formed by forming a film of ITO of 20 nm on the insulating layer 25, and then, the p-electrode 29 and the n-electrode 23 are formed by forming films of Au on the upper surface of the transparent electrode 27 and on the upper surface 17S of the n-type semiconductor layer 17, respectively.

Next, Nb₂O₅ of 40 nm is film-formed as a spacer layer (not illustrated) on the transparent electrode 27, and then, by forming a film of 10.5 pairs of layers made of Nb₂O₅/SiO₂ in one pair on the spacer layer, the second multilayer reflector 31 is formed.

When an AR coating is applied to a back surface of the substrate 11, the back surface of the substrate 11 is finally polished, and then, an AR coating made of Nb₂O₅/SiO₂ is formed on the polished surface to complete the surface emitting laser 10.

### Embodiment 2

The following describes a surface emitting laser 40 as Embodiment 2 of the present invention. The surface emitting laser 40 is different from the surface emitting laser 10 in that, instead of the slit grooves GV1, slit grooves GV2 are formed on the lower surface of the substrate 11, that is, a light emitting surface of the surface emitting laser 40.

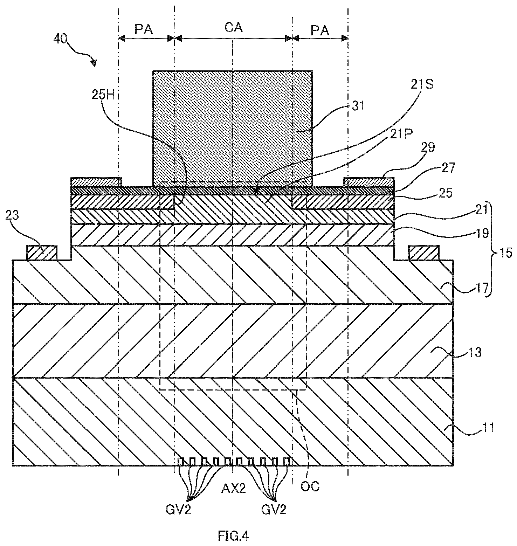

FIG. 4 is a cross-sectional view showing a section of the surface emitting laser 40 taken along a section line similar to that shown in FIG. 2, that is, a section corresponding to FIG. 3.

As shown in FIG. 4, in the surface emitting laser 40, a plurality of slit grooves GV2 are formed in a region in the central region CA on the lower surface of the substrate 11. In other words, the plurality of slit grooves GV2 are formed in a region of the lower surface of the substrate 11 opposed to the opening 25H and the electrical contact surface 21S, that is, in a region from which the emitted light is emitted.

Yet in other words, in the surface emitting laser 40, the plurality of slit grooves GV2 are formed on the lower surface of the substrate 11, and a forming region thereof overlaps with the region in which the slit grooves GV1 of the surface emitting laser 10 of Embodiment 1 are formed in a top view.

The slit grooves GV2 of the surface emitting laser 40 are grooves each of which extends parallel to the axis AX1 on the lower surface of the substrate 11 and is arranged in a direction perpendicular to the axis AX1, that is, slit-like recessed portions. That is, the slit grooves GV2 are grooves extending parallel to each other along the m-axis direction on the lower surface of the substrate 11.

The slit grooves GV2 provide effects similar to those of the slit grooves GV1 in Embodiment 1 described above. That is, the diffraction grating formed of the slit grooves GV2 provides a high reflectivity for a light having a polarization direction in an extending direction of each of the slit grooves GV2 forming the diffraction grating in the central region CA of the reflective structure formed of the first multilayer reflector 13 and the substrate 11.

In other words, the diffraction grating formed of the slit grooves GV2 provides the reflective structure formed of the first multilayer reflector 13 and the substrate 11 with a high reflectivity for the light having the polarization direction in the m-axis direction.

Accordingly, since the slit grooves GV2 are formed, the reflectivity of the light having the polarization direction in the m-axis direction is higher than that of the light having the other polarization directions, and the light having the polarization direction in the m-axis direction is likely to oscillate preferentially in the surface emitting laser 40.

Therefore, with the surface emitting laser 40, the diffraction grating structure made of the slit grooves GV2 is formed on the lower surface of the substrate 11 to perform further polarization control of the emitted light, and thus, similarly to the surface emitting laser 10 of Embodiment 1, it is possible to stably obtain the emitted light in which the light having the polarization direction in the m-axis direction is dominant.

The slit grooves GV2 can be formed by, for example, performing an etching process such as dry etching on the lower surface of the substrate 11 after polishing the lower surface of the substrate 11 in the last step of the manufacturing method of the surface emitting laser 10 of Embodiment 1 described above.

The slit grooves GV2 may extend further outward from the region opposed to the opening 25H, that is, the central region CA. The slit grooves GV2 may be arranged even to the outside of the central region CA.

### Embodiment 3

The following describes a surface emitting laser 50 as Embodiment 3 of the present invention. The surface emitting laser 50 is different from the surface emitting laser 40 in that a convex portion is formed on the lower surface of the substrate 11, that is, the light emitting surface of the surface emitting laser 50 and the slit grooves GV2 described in Embodiment 2 are formed on the surface of the convex portion.

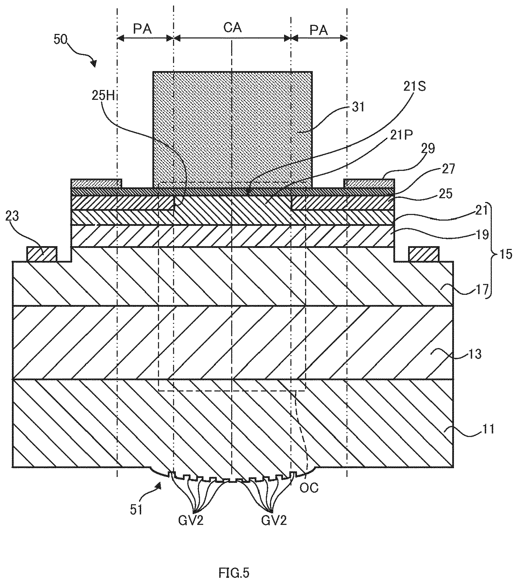

FIG. 5 is a cross-sectional view showing a section of the surface emitting laser 50 taken along a section line similar to that shown in FIG. 2, that is, a section corresponding to FIG. 3. As shown in FIG. 5, in the surface emitting laser 50, a downwardly convex lens-shaped convex portion 51 is formed in a region of the lower surface of the substrate 11 including a region opposed to the opening 25H and the electrical contact surface 21S, that is, the central region CA.

The convex portion 51 has a convex lens shape with the central axis AX2 described in Embodiment 1 as an apex. The plurality of slit grooves GV2 are formed on a surface of the convex portion 51 and each extend in the m-axis direction in the same manner as the surface emitting laser 40 of Embodiment 2.

With the surface emitting laser 50 of Embodiment 3, by providing the convex portion 51, an amount of light reflected toward the central region CA by the reflective structure formed of the first multilayer reflector 13 and the substrate 11 can be increased. Thus, with the surface emitting laser 50, a light oscillation efficiency can be further increased in the central region CA that produces a main part of the emitted light.

For example, the convex portion 51 can be formed by depositing a resist in the same shape as the convex portion 51 on the back surface of the substrate 11 and dry etching the entire back surface of the substrate 11, thereby transferring the shape of the resist to the back surface of the substrate 11.

While the convex portion 51 has a convex lens shape in the above description, the shape of the convex portion 51 may be any other shape as long as the light reflected by the reflective structure made of the first multilayer reflector 13 and the substrate 11 can be collected in the central region CA. For example, the convex portion 51 may have a parabolic shape convex downward.

The slit grooves GV2 may extend further outward from the region opposed to the opening 25H, that is, the central region CA. The slit grooves GV2 may be arranged even to the outside of the central region CA. The slit grooves GV2 may extend even to an outside of the convex portion 51. The slit grooves GV2 may be arranged even to the outside of the convex portion 51.

### Embodiment 4

The following describes a surface emitting laser 60 as Embodiment 4 of the present invention. The surface emitting laser 60 is different from the surface emitting laser 10 in that, instead of the slit grooves GV1, slit grooves GV3 are formed on the upper surface of the first multilayer reflector 13. That is, in the surface emitting laser 60, the hollow slit grooves GV3 are formed along an interface between the first multilayer reflector 13 and the semiconductor structure layer 15.

In other words, in the surface emitting laser 60, a hollow diffraction grating structure made of the slit grooves GV3 is formed along the interface between the first multilayer reflector 13 and the semiconductor structure layer 15.

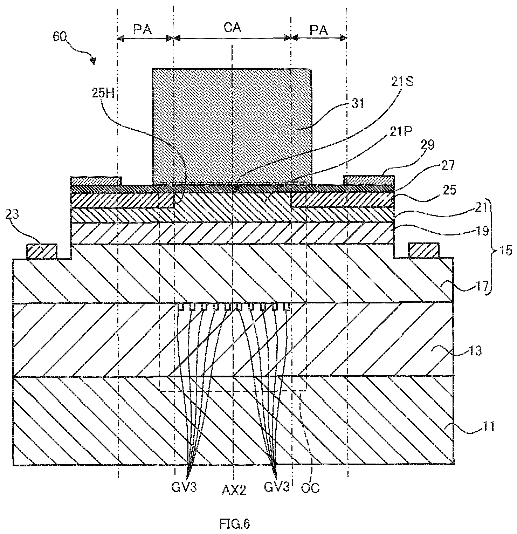

FIG. 6 is a cross-sectional view showing a section of the surface emitting laser 60 taken along a section line similar to that shown in FIG. 2, that is, a section corresponding to FIG. 3. As shown in FIG. 6, in the surface emitting laser 60, a plurality of slit grooves GV3 are formed in a region of a lower surface of the n-type semiconductor layer 17 opposed to the opening 25H and the electrical contact surface 21S, that is, the central region CA. In other words, in the surface emitting laser 60, the plurality of slit grooves GV3 are formed on the lower surface of the n-type semiconductor layer 17, and a forming region thereof overlaps with the region in which the slit grooves GV1 of the surface emitting laser 10 of Embodiment 1 are formed in a top view.

The slit grooves GV3 of the surface emitting laser 60 are grooves each of which extends parallel to the axis AX1 (see FIG. 2) on the upper surface of the first multilayer reflector 13 and is arranged in the direction perpendicular to the axis AX1, that is, slit-like recessed portions. That is, the slit grooves GV3 are grooves extending parallel to each other along the m-axis direction at the interface between the first multilayer reflector 13 and the semiconductor structure layer 15, and forms a diffraction grating structure made of slits extending along the m-axis direction.

The slit grooves GV3 provide effects similar to those of the slit grooves GV1 in Embodiment 1 described above. That is, the diffraction grating formed of the slit grooves GV3 provides a high reflectivity for a light having a polarization direction in an extending direction of each of the slit grooves GV3, that is, in the m-axis direction, in the central region CA of the reflective structure formed of the first multilayer reflector 13 and the substrate 11. Accordingly, since the slit grooves GV3 are formed, the reflectivity of the light having the polarization direction in the m-axis direction is higher than that of the light having the other polarization directions, and the light having the polarization direction in the m-axis direction is likely to oscillate preferentially.

Therefore, with the surface emitting laser 60, the diffraction grating structure made of the slit grooves GV3 is formed at the interface between the first multilayer reflector 13 and the semiconductor structure layer 15 to perform polarization control of the emitted light, and thus, similarly to the surface emitting laser 10 of Embodiment 1, it is possible to stably obtain the emitted light in which the light having the one polarization direction is dominant.

In the surface emitting laser 60, the diffraction grating structure made of the slit grooves GV3 is formed in a region between the first multilayer reflector 13 and the second multilayer reflector 31. That is, in the surface emitting laser 60, the slit grooves GV3 forming the diffraction grating structure are provided at a position closer to the active layer 19 as compared with the surface emitting lasers 10, 40, and 50 of Embodiments 1 to 3 described above.

Accordingly, in the surface emitting laser 60, an intensity of the emitted light from the active layer 19 in a region in which the slit grooves GV3 are formed is larger than those in the surface emitting lasers 10, 40, and 50 of the other embodiments. Thus, more light can be reflected by the diffraction grating structure formed of the slit grooves GV3, and the above-described polarization control effect is higher than those of the surface emitting lasers of the other embodiments. Therefore, in the surface emitting laser 60, it is possible to stably obtain the emitted light in which the light having the one polarization direction is more dominant compared with the surface emitting lasers of the other embodiments described above.

The slit grooves GV3 can be formed as follows. A GaN layer is used as the uppermost layer of the first multilayer reflector 13, and the GaN layer as the uppermost layer is etched to form the slit grooves GV3. Subsequently, the GaN layer is grown and planarized so as to cover a portion from which the GaN has been removed, that is, so as not to fill the slit grooves GV3. Subsequently, an n-GaN layer is grown on the planarized surface to form the n-type semiconductor layer 17.

The slit grooves GV3 may extend further outward from the region opposed to the opening 25H, that is, the central region CA. The slit grooves GV3 may be arranged even to the outside of the central region CA.

The diffraction grating structure formed of the slit grooves GV3 does not need to have a hollow structure. That is, an embedded-type (embedded structure) diffraction grating structure in which the slit grooves GV3 is filled with the semiconductor material may be provided.

When the embedded-type diffraction grating structure is provided, in the manufacture of the surface emitting laser 60, an AlInN layer is used as the uppermost layer of the first multilayer reflector 13, and after forming the slit grooves GV3 on the AlInN layer as the uppermost layer by etching, the GaN layer is grown and planarized so as to fill the slit grooves GV3, and then, the n-GaN layer is grown on the planarized surface to form the n-type semiconductor layer 17.

The slit grooves GV3 may be filled with GaN or may remain hollow depending on the growth conditions for growing the GaN layers on the slit grooves GV3. Accordingly, the diffraction grating structure formed of the slit grooves GV3 may have either the embedded structure or the hollow structure.

Of course, when the diffraction grating structure formed of the slit grooves GV3 has the embedded structure, the polarization control effect similar to the diffraction grating structure of the hollow structure can be achieved.

### Embodiment 5

The following describes a surface emitting laser 70 as Embodiment 5 of the present invention. The surface emitting laser 70 is different from the surface emitting laser 10 of Embodiment 1 in that, instead of the insulating layer 25, a tunnel junction structure is formed in the semiconductor structure layer 15 to form the current confinement structure described above. Specifically, the surface emitting laser 70 differs from the surface emitting laser 10 in the structure above the p-type semiconductor layer 21.

The surface emitting laser 70 is also different from the surface emitting laser 10 in that, instead of the slit grooves GV1, slit grooves GV4 formed along an interface between the semiconductor structure layer 15 and a second multilayer reflector 75 are used to form the diffraction grating structure.

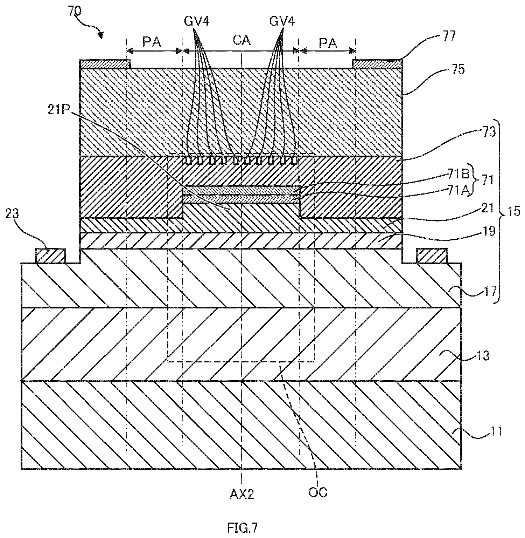

FIG. 7 is a cross-sectional view showing a section of the surface emitting laser 70 taken along a section line similar to that shown in FIG. 2, that is, a section corresponding to FIG. 3. As shown in FIG. 7, in the surface emitting laser 70, a tunnel junction layer 71 is formed on the projecting portion 21P of the p-type semiconductor layer 21. That is, in the surface emitting laser 70, the tunnel junction layer 71 is formed in the central region CA in the semiconductor structure layer 15.

The tunnel junction layer 71 includes: a high dope p-type semiconductor layer 71A that is a p-type semiconductor layer formed on the p-type semiconductor layer 21 and has an impurity concentration higher than that of the p-type semiconductor layer 21; and a high dope n-type semiconductor layer 71B that is an n-type semiconductor layer formed on the high dope p-type semiconductor layer 71A and has an impurity concentration higher than that of the n-type semiconductor layer 17.

An n-type semiconductor layer 73 is formed on the p-type semiconductor layer 21 and the tunnel junction layer 71. The n-type semiconductor layer 73 is formed to embed the tunnel junction layer 71 at the upper surface of the p-type semiconductor layer 21. In other words, the n-type semiconductor layer 73 is formed so as to cover a side surface of the projecting portion 21P as well as a side surface and an upper surface of the tunnel junction layer 71.

The second multilayer reflector 75 is an n-type semiconductor layer formed on the upper surface of the n-type semiconductor layer 73 and having a doping concentration similar to that of the n-type semiconductor layer 17. That is, the n-type semiconductor layer 73 has a doping concentration lower than that of the high dope n-type semiconductor layer 71B.

The stacked structure made of the p-type semiconductor layer 21, the tunnel junction layer 71, and the n-type semiconductor layer 73 produces a tunneling effect at the tunnel junction layer 71 portion. As a result, in the surface emitting laser 70, a current confinement structure in which a current flows only in the portion of the tunnel junction layer 71 and is confined to the central region CA is formed between the p-type semiconductor layer 21 and the n-type semiconductor layer 73.

The second multilayer reflector 75 is a semiconductor multilayer reflector made of a semiconductor layer formed on the n-type semiconductor layer 73. The second multilayer reflector 75 is formed by alternately stacking a low refractive-index semiconductor film having a composition of AlInN and a high refractive-index semiconductor film having a GaN composition and having a refractive index higher than that of the low refractive-index semiconductor film, and has n-type semiconductor properties. In other words, the second multilayer reflector 75 is a distributed Bragg reflector (DBR) made of a semiconductor material.

A second n-electrode 77 is a metal electrode formed along a peripheral edge portion of an upper surface of the second multilayer reflector 75. In the surface emitting laser 70, since the second multilayer reflector 75 has a conductive property, a current flows from the second n-electrode 77 through the second multilayer reflector 75, the n-type semiconductor layer 73, the tunnel junction layer 71, the p-type semiconductor layer 21, the active layer 19, and the n-type semiconductor layer 17 to the n-electrode 23.

In the surface emitting laser 70, the slit grooves GV4 are grooves formed in a region immediately above the tunnel junction layer 71 on the upper surface of the n-type semiconductor layer 73 and extending in the m-axis direction. The second multilayer reflector 75 on the slit grooves GV4 is stacked so as to cover the slit grooves GV4. That is, the slit grooves GV4 are hollow inside, and a diffraction grating structure made of a hollow space is formed of the slit grooves GV4.

The slit grooves GV4 provide effects similar to those of the slit grooves GV1 in Embodiment 1 described above. That is, the diffraction grating formed of the slit grooves GV4 provides a high reflectivity for a light having a polarization direction in an extending direction of each of the slit grooves GV4 forming the diffraction grating, that is, in the m-axis direction, in the central region CA of the reflective structure formed of the second multilayer reflector 75. Accordingly, since the slit grooves GV4 are formed, the reflectivity of the light having the polarization direction in the m-axis direction is higher than that of the light having the other polarization directions, and the light having the polarization direction in the m-axis direction is likely to oscillate preferentially.

Therefore, with the surface emitting laser 70, the diffraction grating structure made of the slit grooves GV4 is formed on the upper surface of the n-type semiconductor layer 73 to perform polarization control of the emitted light, and thus, similarly to the surface emitting laser 10 of Embodiment 1, it is possible to stably obtain the emitted light in which the light having the one polarization direction is dominant.

In the surface emitting laser 70, the slit grooves GV4 are formed along the interface between the semiconductor structure layer 15 and the second multilayer reflector 75. That is, in the surface emitting laser 70, the slit grooves GV4 forming the diffraction grating structure are provided at a position closer to the active layer 19 as compared with the surface emitting lasers 10, 40, and 50 of Embodiments 1 to 3 described above.

Accordingly, in the surface emitting laser 70, an intensity of the emitted light from the active layer 19 in a region in which the slit grooves GV4 are formed is larger than those in the surface emitting lasers 10, 40, and 50 of Embodiments 1 to 3. Thus, more light can be reflected by the diffraction grating structure formed of the slit grooves GV4, and the above-described polarization control effect is higher than those of the surface emitting lasers of the other embodiments. Therefore, in the surface emitting laser 70, it is possible to stably obtain the emitted light in which the light having the one polarization direction is more dominant compared with the surface emitting lasers of Embodiments 1 to 3 described above.

The slit grooves GV4 can be formed as follows. The slit grooves GV4 are formed on the upper surface of the n-type semiconductor layer 73 by etching. Subsequently, an n-GaN layer, which is also a part of the n-type semiconductor layer 73, is formed so as to cover the slit grooves GV4 and planarized. Subsequently, the second multilayer reflector 75 is formed.

The slit grooves GV4 may extend not only in the central region CA, but may extend further outward. The slit grooves GV4 may be arranged even to the outside of the central region CA.

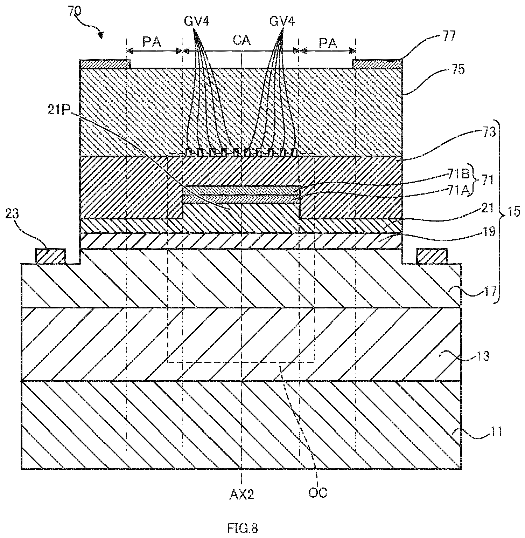

As shown in FIG. 8, the slit grooves GV4 may be formed on a lower surface of the second multilayer reflector 75. In this case, the slit grooves GV4 can be formed by etching an n-AlInN layer as the first layer of the second multilayer reflector 75 to form grooves forming the slit grooves, and then, forming an n-GaN layer so as to cover the grooves from above and planarizing the n-GaN layer, and then, forming a thin film layer of the second multilayer reflector 75.

In above-described Embodiments 1 to 4, in order to form the electrical contact surface 21S and the insulating region around the electrical contact surface 21S on the upper surface of the p-type semiconductor layer 21 to cause the current confinement and to form a region having a low refractive index, the insulating layer 25 is disposed. However, instead of disposing the insulating layer 25, other methods may be used to cause the current confinement and create the region having a low refractive index.

For example, the insulating region, the region having a low refractive index, and the electrical contact surface 21S may be formed by etching the upper surface of the p-type semiconductor layer 21 on which the insulating layer 25 is disposed in the above-described embodiments. By performing ion implantation on the upper surface of the p-type semiconductor layer 21 on which the insulating layer 25 is disposed, the insulating region, the region having a low refractive index, and the electrical contact surface 21S may be formed to produce a current confinement effect similar to that of forming the insulating layer 25 in the above-described embodiments. When the ion implantation is performed, for example, B ions, Al ions, or oxygen ions are implanted into the p-type semiconductor layer 21.

In the above-described embodiments, a case in which the upper surface of the substrate 11 is a surface offset from the C-plane by 0.5° in the M-plane direction, that is, a case in which the off angle from the C-plane in the M-plane direction is 0.5° has been described. However, the off angle is not limited to this angle. When the off angle is, for example, about 0.3° to 0.8°, the above-described polarization control effect can be sufficiently obtained. When the off angle of the upper surface of the substrate 11 is 0.8° or less, the semiconductor multilayer constituting the first multilayer reflector 13 can be formed so as to stably have a satisfactory reflectivity.

In the above-described embodiments, while a coreless substrate is used as the substrate 11, a stripe core substrate may also be used. In this case, in a top view of the substrate 11, a stripe direction of cores of the substrate 11 and an inclined direction of a crystal face of the upper surface of the substrate 11 are parallel or perpendicular to each other. That is, in the above-described embodiments, the m-axis direction of the substrate 11 and the stripe direction of the cores of the substrate 11 are parallel or perpendicular to each other.

In the above-described embodiments, a case in which the upper surface of the substrate 11 is offset from the C-plane in the M-plane direction has been described. However, the upper surface of the substrate 11 may be offset from the C-plane in the A-plane direction and may be hardly offset in the M-plane direction.

In this case, in order to obtain the above-described polarization control effect, for the same reason as the description of the range of the off angle of the C-plane described above, the off angle from the C-plane in the A-plane direction is preferably about 0.3° to 0.8°, and the off angle from the C-plane to the M-plane is preferably 0 ± 0.1°. When the upper surface of the substrate 11 is offset from the C-plane to the A-plane, it should be understood that AX1 corresponds to the a-axis in the description of the shape of the electrical contact surface 21S in the above-described embodiments.

When the upper surface of the substrate 11 is offset from the C-plane in the A-plane direction, a large amount of light having a polarization direction along the a-axis direction can be taken out, and emission of a light having a polarization direction other than the direction along the a-axis can be suppressed. Therefore, with the surface emitting laser 10, it is possible to suppress variation in a polarization direction of the light extracted from the light emitting surface in the in-plane direction of the light emitting surface.

In the above-described embodiments, while a case in which the upper surface of the substrate 11 is offset from the C-plane in the M-plane direction or the A-plane direction has been described, the upper surface of the substrate 11 does not have to be offset from the C-plane. Even in this case, the diffraction grating structure formed of the slit grooves GV1, GV2, GV3, and GV4 described above preferentially oscillates a light having a polarization direction parallel to the slit grooves, and it is possible to obtain an emitted light in which the light having the polarization direction parallel to the slit grooves is dominant.

In Embodiment 3, a case in which the convex portion 51 is formed and the slit grooves GV2 are formed on the lower surface of the convex portion 51 has been described. However, the convex portion 51 may be formed on the lower surface of the substrate of the surface emitting laser in other embodiments other than Embodiment 3. When the convex portion 51 is formed in the surface emitting laser of other embodiments, the convex portion 51 still produces an effect of increasing the amount of light reflected to the central region CA. That is, when the convex portion 51 is formed in the surface emitting laser of other embodiments, it is also possible to obtain an effect of further increasing the light oscillation efficiency in the central region CA that produces the main part of the emitted light.

Various numerical values, dimensions, materials, and the like in the embodiments described above are merely examples, and can be appropriately selected depending on the usage and the surface emitting laser to be manufactured.

### DESCRIPTION OF REFERENCE SIGNS

- 10, 40, 50, 60, 70: Surface emitting laser
- 11: Substrate
- 13: First multilayer reflector
- 15: Semiconductor structure layer
- 17: n-type semiconductor layer
- 19: Active layer
- 21: p-type semiconductor layer
- 23: n-electrode
- 25: Insulating layer
- 27: Transparent electrode
- 29: p-electrode
- 31: Second multilayer reflector
- 71: Tunnel junction layer
- 73: n-type semiconductor layer
- 75: Second multilayer reflector
- 77: Second n-electrode

## Claims

1. A vertical cavity light-emitting element comprising:
a gallium-nitride-based semiconductor substrate;
a first multilayer reflector made of a nitride semiconductor formed on the substrate;
a semiconductor structure layer including a first semiconductor layer, an active layer, and a second semiconductor layer, the first semiconductor layer being made of a nitride semiconductor having a first conductivity type formed on the first multilayer reflector, the active layer being made of a nitride semiconductor formed on the first semiconductor layer, the second semiconductor layer being formed on the active layer and made of a nitride semiconductor having a second conductivity type opposite to the first conductivity type;
a second multilayer reflector formed on the semiconductor structure layer, the second multilayer reflector constituting a resonator with the first multilayer reflector; and
a current confinement structure formed between the first multilayer reflector and the second multilayer reflector to concentrate a current in one region of the active layer, wherein
a diffraction grating is formed in a region overlapping with the one region when viewed from a normal direction of an upper surface of the gallium-nitride-based semiconductor substrate, the diffraction grating being made of a plurality of slit structures parallel to each other.

2. The vertical cavity light-emitting element according to claim 1, wherein
the plurality of slit structures are formed between the first multilayer reflector and the second multilayer reflector.

3. The vertical cavity light-emitting element according to claim 1, wherein
each of the plurality of slit structures is a recessed portion formed on a back surface of the substrate.

4. The vertical cavity light-emitting element according to any one of claims 1 to 3, wherein
the upper surface of the gallium-nitride-based semiconductor substrate is a surface offset from a C-plane to a crystal face of an M-plane or an A-plane, and
each of the plurality of slit structures extends in an m-axis direction when the upper surface is offset to the M-plane and extends in an a-axis direction when the upper surface is offset to the A-plane.

5. The vertical cavity light-emitting element according to claim 4, wherein
the upper surface of the gallium-nitride-based semiconductor substrate is a surface offset from a C-plane by an angle of 0.8° or less to the M-plane when the upper surface is offset to the M-plane and is a surface offset from the C-plane to the A-plane by an angle of 0.8° or less when the upper surface is offset to the A-plane.

6. The vertical cavity light-emitting element according to claim 4 or 5, wherein
the gallium-nitride-based semiconductor substrate is a stripe core substrate, and a direction in which a core of the gallium-nitride-based semiconductor substrate extends is a direction along the m-axis when the upper surface is offset to the M-plane and is a direction along the a-axis when the upper surface is offset to the A-plane.

7. The vertical cavity light-emitting element according to any one of claims 1 to 6, wherein
a region of a lower surface of the gallium-nitride-based semiconductor substrate overlapping with the one region when viewed from the normal direction of the upper surface of the gallium-nitride-based semiconductor substrate has a convex lens-shape convex downward.

## Amended claims

### Amended claims under Art. 19.1 PCT

1. (amended) A vertical cavity light-emitting element comprising:
a gallium-nitride-based semiconductor substrate;
a first multilayer reflector made of a nitride semiconductor formed on the substrate;
a semiconductor structure layer including a first semiconductor layer, an active layer, and a second semiconductor layer, the first semiconductor layer being made of a nitride semiconductor having a first conductivity type formed on the first multilayer reflector, the active layer being made of a nitride semiconductor formed on the first semiconductor layer, the second semiconductor layer being formed on the active layer and made of a nitride semiconductor having a second conductivity type opposite to the first conductivity type;
a second multilayer reflector formed on the semiconductor structure layer, the second multilayer reflector constituting a resonator with the first multilayer reflector; and
a current confinement structure formed between the first multilayer reflector and the second multilayer reflector to concentrate a current in one region of the active layer, wherein
a diffraction grating is formed in a region overlapping with the one region when viewed from a normal direction of an upper surface of the gallium-nitride-based semiconductor substrate, the diffraction grating being made of a plurality of slit structures parallel to each other, and
each of the plurality of slit structures is a recessed portion formed on a back surface of the substrate.

2. The vertical cavity light-emitting element according to claim 1, wherein
the plurality of slit structures are formed between the first multilayer reflector and the second multilayer reflector.

3. (deleted)

4. (amended) The vertical cavity light-emitting element according to claim 1 or 2, wherein
the upper surface of the gallium-nitride-based semiconductor substrate is a surface offset from a C-plane to a crystal face of an M-plane or an A-plane, and
each of the plurality of slit structures extends in an m-axis direction when the upper surface is offset to the M-plane and extends in an a-axis direction when the upper surface is offset to the A-plane.

5. The vertical cavity light-emitting element according to claim 4, wherein
the upper surface of the gallium-nitride-based semiconductor substrate is a surface offset from a C-plane by an angle of 0.8° or less to the M-plane when the upper surface is offset to the M-plane and is a surface offset from the C-plane to the A-plane by an angle of 0.8° or less when the upper surface is offset to the A-plane.

6. The vertical cavity light-emitting element according to claim 4 or 5, wherein
the gallium-nitride-based semiconductor substrate is a stripe core substrate, and a direction in which a core of the gallium-nitride-based semiconductor substrate extends is a direction along the m-axis when the upper surface is offset to the M-plane and is a direction along the a-axis when the upper surface is offset to the A-plane.

7. The vertical cavity light-emitting element according to any one of claims 1 to 6, wherein
a region of a lower surface of the gallium-nitride-based semiconductor substrate overlapping with the one region when viewed from the normal direction of the upper surface of the gallium-nitride-based semiconductor substrate has a convex lens-shape convex downward.

Statement under Art. 19.1 PCT
1. changes made by the amendment
(1) The contents of claim 3 before the amendment were introduced into claim 1 before the amendment.
(2) Claim 3 before the amendment was deleted.
(3) Dependent relationship of claim 4 was amended in accordance with the deletion of claim 3.
   Explanation of the amendment
   The description "each of the plurality of slit structures is a recessed portion formed on a back surface of the substrate" in claim 3 before the amendment, which was found to have inventive step in the opinion of International. Searching Authority, is incorporated in claim 1 after the amendment.
   The vertical cavity light emitting devices recited in paragraphs 1-7 of the claims as amended, which have the above configuration, are not recited in any of the cited references.
